Europäisches Patentamt

European Patent Office

Office européen des brevets

(11) Veröffentlichungsnummer: **0 110 401**
**B1**

(12) **EUROPÄISCHE PATENTSCHRIFT**

(45) Veröffentlichungstag der Patentschrift: **25.05.88**

(21) Anmeldenummer: **83112024.1**

(22) Anmeldetag: **30.11.83**

(51) Int. Cl.⁴: **H 01 L 23/52**

(54) **Integrierte Halbleiterschaltung mit einer aus einer Aluminium/Silizium-Legierung bestehenden Kontaktleiterebene.**

(30) Priorität: **01.12.82 DE 3244461**

(43) Veröffentlichungstag der Anmeldung:
**13.06.84 Patentblatt 84/24**

(45) Bekanntmachung des Hinweises auf die Patenterteilung:
**25.05.88 Patentblatt 88/21**

(84) Benannte Vertragsstaaten:
**AT CH DE FR GB IT LI SE**

(56) Entgegenhaltungen:
**THIN SOLID FILMS, Band 83, Nr. 2, September 1981, Seiten 195-205, Elsevier Sequoia, Lausanne, gedruckt in Holland; P.B. GHATE: Aluminum alloy metallization for integrated circuis"**

Die Akte enthält technische Angaben, die nach dem Eingang der Anmeldung eingereicht wurden und die nicht in dieser Patentschrift enthalten sind.

(73) Patentinhaber: **Siemens Aktiengesellschaft Berlin und München Wittelsbacherplatz 2 D-8000 München 2 (DE)**

(72) Erfinder: **Fischer, Franz, Dr. Ing. Phys. Gerstäckerstrasse 32 D-8000 München 82 (DE)**

(56) Entgegenhaltungen:
**IBM TECHNICAL DISCLOSURE BULLETIN, Band 20, nr. 9, Februar 1978, Seiten 3477-3479, Armonk, US; J.K. HOWARD u.a.: "Fabrication of intermetallic diffusion barriers for electromigration in narrow-line stripes"**

## Beschreibung

Die Patentanmeldung betrifft eine integrierte Schaltung mit einem aus Silizium bestehenden Halbleitersubstrat, in dem und auf dem die die Schaltung bildenden Elemente erzeugt sind und mit einer aus einer Aluminium/Silizium-Legierung bestehenden Kontaktleiterbahnebene.

Die Erfindung dient zur Lösung der Aufgabe, die Zuverlässigkeit und Belastbarkeit von elektrischen Leiterbahnen für VLSI-Systeme (= very large scale integration) zu erhöhen, ohne daß zusätzliche und kostenaufwendige Maßnahmen erforderlich werden.

Integrierte Halbleiterschaltungen mit Aluminium/Silizium-Leiterbahnebenen, bei denen zur Erhöhung der Zuverlässigkeit und der Belastbarkeit zur thermischen Anpassung der leitenden Metallschicht an das Siliziumoxid eine Zwischenschicht aus Titan verwendet wird, sind aus einem Aufsatz von H. Murrmann "Modern Bipolar Technology for High-Performance ICs" aus den Siemens Forschungs- und Entwicklungsberichten, Band 5 (1976), Nr. 6, Seiten 353 bis 359 bekannt.

In dem Aufsatz von P. B. Ghate und I. C. Blair aus Thin Solid Films 55 (1978) Seiten 113—123 werden für den gleichen Zweck Zwischenschichten aus Titan-Wolfram verwendet.

Aus dem IBM J. Res. Rev. 14 (1970) Seite 461—463 ist aus einem Bericht von I. Ames, F. d'Heurle und R. Horstmann zu entnehmen, daß durch eine Beimengung von 4% Kupfer zum Aluminium die elektrische Materialwanderung verringert werden kann.

Hochzuverlässige Leiterbahnen werden aus Gold mit Zwischenschichten aus Titan und Platin gefertigt (siehe M. P. Lepselter, Bell Syst. Techn. J. 45 (1966) Seiten 233 bis 253). Aus dem gleichen Bericht ist auch zu entnehmen, daß stabile niederohmige Kontakte zwischen Metall und Silizium im Kontaktloch durch Platinsilizid realisiert werden.

Alle diese Metallisierungen erfordern zusätzliche Zwischenschichten und damit zusätzliche Prozeßschritte, welche erhebliche Mehrkosten verursachen und die Fehlerquote bei der Herstellung der integrierten Schaltung erhöhen können.

Die Erfindung löst die eingangs gestellte Aufgabe auf eine andere Weise und erzielt damit eine gewisse Vereinfachung und andere Verbesserungen gegenüber den bekannten Anordnungen. Sie betrifft deshalb eine integrierte Halbleiterschaltung der eingangs genannten Art, die gekennzeichnet ist durch eine Aluminium/Silizium-Legierung mit einem Anteil von 1 bis 2%. Silizium und einem Titanzusatz von O<Ti≤0.5%. Gemäß einem besonders günstigen Ausführungsbeispiel beträgt der Titanzusatz bei einem Anteil von 1% Silizium in der Aluminium/Silizium-Legierung 0,1 bis 0,5%.

Es liegt im Rahmen der Erfindung, daß die Aluminium/Silizium/Titan-Legierung durch Hochfrequenz-Zerstäuben hergestellt ist, wobei die Legierungsbestandteile bei der Abscheidung gleich in die Aluminiumschicht miteingebaut werden.

Folgende Vorteile ergeben sich durch die Erfindung:

1. Die thermische Anpassung zwischen Metall und SiO$_2$ wird besser; die Haftfestigkeit degradiert auch bei hohen Belastungen langsamer als bei Aluminium/Silizium-Schichten.

2. Die Bildung niederohmiger, stabiler Kontakte zwischen Metall, Silizium oder Polysilizium, sowie zu Tantal-, Wolfram-, Titan- und Molybdän-Siliziden ist auch ohne Zwischenschicht gewährleistet.

3. Die Oxidschicht auf der Metalloberfläche bleibt dicht; deshalb ist die Metallschicht nicht anfällig gegen Korrosion.

4. Die Korngrenzendiffusion wird beträchtlich kleiner; dadurch verringert sich auch elektrische Materialwanderung.

5. Titan wirkt im Aluminium stark kornverfeinernd und erhöht die mechanische Festigkeit. Das Gefüge wird homogenisiert und stabilisiert, wodurch es elektrisch stärker belastbar wird.

6. Durch die Titanmenge im Aluminium wird die Kontaktierbarkeit verbessert.

7. Die Fertigung der Leiterbahnen erfordert im Vergleich mit der Standardtechnologie keine zusätzlichen Prozeßschritte also auch keine Mehrkosten.

Die unter 1 bis 6 beschriebenen Eigenschaften der Aluminium/Silizium/Titan-Metallisierung bewirken eine Zunahme des Wertes der mittleren Ausfallzeit (MTF-Wert = mean time to failure) bei Stressbelastung um den Faktor 30 im Vergleich zur Aluminium/Silizium-Metallisierung. Damit ist ihre Zuverlässigkeit mit den bekannten Mehrschichtmetallisierungen gleichzusetzen.

## Patentansprüche

1. Integrierte Schaltung mit einem aus Silizium bestehenden Halbleitersubstrat, in dem und auf dem die die Schaltung bildenden Elemente erzeugt sind, und mit einer aus einer Aluminium/Silizium-Legierung bestehenden Kontaktleiterbahnebene, gekennzeichnet durch eine Aluminium/Silizium-Legierung mit einem Anteil von 1 bis 2% Silizium und einem Titanzusatz von O<Ti≤0.5%.

2. Integrierte Halbleiterschaltung nach Anspruch 1, dadurch gekennzeichnet, daß der Titanzusatz bei einem Anteil von 1% Silizium in der Legierung 0,1 bis 0,5% beträgt.

3. Integrierte Halbleiterschaltung nach Anspruch 1 und/oder 2, dadurch gekennzeichnet, daß die Aluminium/Silizium/Titan-Legierung durch Hochfrequenz-Zerstäuben hergestellt ist, wobei die Legierungsbestandteile bei der Abscheidung gleich in die Aluminiumschicht mit eingebaut werden.

## Revendications

1. Circuit intégré comportant un substrat semiconducteur constitué par du silicium et dans et sur lequel on forme les éléments constituant le circuit, et un plan des voies conductrices de contact constitué par alliage aluminium/silicium, caractérisé par un alliage aluminium/silicium possédant un pourcentage de silicium compris entre 1 et 2% et une adjonction de titane 0<Ti≤0,5%.

2. Circuit intégré à semiconducteurs suivant la revendication 1, caractérisé par le fait que l'adjonction de titane est comprise entre 0,1 et 0,5% dans le cas d'un pourcentage de 1% de silicium dans l'alliage.

3. Circuit intégré à semiconducteurs suivant la revendication 1 et/ou 2, caractérisé par le fait que l'alliage aluminium/silicium/titane est fabriqué par pulvérisation à haute fréquence, auquel cas les composants de l'alliage sont insérés conjointement d'une manière identique dans la couche d'aluminium lors du dépôt.

**Claims**

1. An integrated circuit comprising a semiconductor substrate which consists of silicon in which and on which the elements which form the circuit are produced, and comprising a contact conductor path layer which consists of an aluminium/silicon alloy, characterised by an aluminium/silicon alloy having a silicon component of 1 to 2% and a titanium addition of O<Ti≤0.5%.

2. An integrated semiconductor circuit as claimed in Claim 1, characterised in that with a silicon component of 1% in the alloy the titanium addition is 0.1 to 0.5%.

3. An integrated semiconductor circuit as claimed in Claim 1 and/or 2, characterised in that the aluminium/silicon/titanium alloy is produced by high-frequency sputtering, in which the alloy constituents are similarly incorporated into the aluminium layer during the deposition.